Europäisches Patentamt

European Patent Office

Office européen des brevets

(11) Publication number: **0 434 850 A1**

# EUROPEAN PATENT APPLICATION
## published in accordance with Art. 158(3) EPC

(21) Application number: 90910927.4

(22) Date of filing: 16.07.90

(86) International application number:
PCT/JP90/00918

(87) International publication number:
WO 91/01570 (07.02.91 91/04)

(51) Int. Cl.⁵: **H01L 29/784**

(30) Priority: 18.07.89 JP 186683/89

(43) Date of publication of application:
03.07.91 Bulletin 91/27

(84) Designated Contracting States:
DE FR GB NL

(71) Applicant: **SEIKO INSTRUMENTS INC.**
**31-1, Kameido 6-chome Koto-ku**
**Tokyo 136(JP)**

(72) Inventor: **AOKI, Kenji Seiko Instruments Inc.**
**31-1, Kameido 6-chome Koto-ku**
**Tokyo 136(JP)**

(74) Representative: **Fleuchaus, Leo, Dipl.-Ing. et al**
**Melchiorstrasse 42**
**W-8000 München 71(DE)**

(54) SEMICONDUCTOR DEVICE.

(57) A semiconductor device which is used as a switching element of computers and which is featured by a high-speed operation and, particularly, an insulated gate field-effect transistor. The following means is adopted in order to develop the impact ionization phenomenon, that has been observed only when the channel length is short and the power source voltage is high, even under the condition of a low power source voltage and a long channel length. First, the impurity concentration is increased in the semiconductor region to decrease the width of the depletion layer between the drain and the substrate. Accordingly the impact ionization phenomenon takes place sufficiently even when the drain voltage $V_D$ is lower than 5 V. Second, a high-resistance layer is interposed between the semiconductor region and the substrate electrode so that holes or electrons accumulate in the substrate. Hence, minority carriers are injected from the source. Third, in order to prevent Vth from rising as a result of using the semiconductor substrate having a high impurity concentration, a low impurity concentration region is formed on the substrate surface to use it as a channel. Owing to the above-mentioned means, very great current drivability is realized even by the use of ordinary power source voltage, independent of the device size, and by the injection of minority carriers from the source that is triggered by the impact ionization phenomenon near the drain.

EP 0 434 850 A1

source electrode

3a ソース電極  6a デート電極

gate electrode

4a ドレイン電極  drain electrode

V_G  V_D

6  5

3  4

n+  n+

9  フィールド酸化膜  field oxide film

2 低不純物濃度領域  low impurity concentration region

1 半導体領域  semiconductor substrate

P+

P−

7 高低抗層  high resistance layer

8 基板電極  substrate electrode

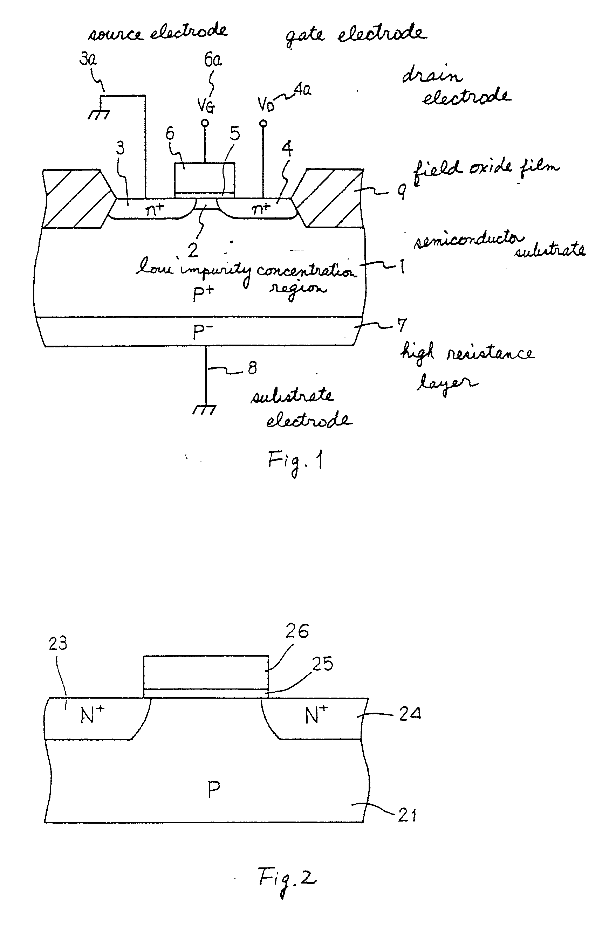

第 1 図  Fig. 1

2

## SEMICONDUCTOR DEVICE

### FIELD OF THE INVENTION

The present invention relates to a semiconductor device, and especially relates to a metal-insulator-semiconductor field effect transistor (hereinafter called MISFET) utilized as a switching element in a computer and characterized by a high-speed operation.

The present invention employs a substrate having a high impurity concentration to enhance the field strength between the substrate and a drain. In addition, a high-resistance load is provided in series between a semiconductor region (a semiconductor substrate or a well) and a substrate electrode in order to cause a rapid increase in drain current that is triggered by an impact ionization phenomenon occurring in the vicinity of the drain at the same time as a MIS transistor operation starts, thereby realizing a high current driving capability.

### BACKGROUND OF THE INVENTION

In a conventional MIS transistor, as shown in Fig.2, a gate insulating film 25 and a gate electrode 26 are formed on a semiconductor substrate 21 successively in a mentioned order, and a source 23 and a drain 24 are formed by ion implantation.

In order to cause the above described phenomenon in the MOS transistor having the conventional structure, the channel length L must be small and the operating voltage must be high ($V_D \geq$ 10v), as reported, for example, in IEEE, EDL-8, No.7, July, 1987.

Accordingly, as long as it is used at an ordinary power supply voltage (5V or lower), the MIS transistor having the conventional structure can realize only such a limited current driving capability that is dependent on the power supply voltage V, device size W/L, carrier mobility $\mu$, etc.

An object of the present invention is to enable the phenomenon, which occurs only when the channel is short and the power supply voltage is high in the prior art, to occur even when the power supply voltage is low and the channel is long.

### DISCLOSURE OF THE INVENTION

Accordingly, the present invention adopts means described below in order to enable the phenomenon, which occurs only when the channel is short and the power supply voltage is high in the prior art, to occur even when the power supply voltage is low and the channel is long. First, the impurity concentration in a semiconductor region (which is a substrate or a well) is raised to reduce the width of the depletion layer between a drain and a substrate, thereby enabling the impact ionization phenomenon to occur satisfactorily, even when the drain voltage $V_D$ is 5V or lower. Second, a high-resistance layer is provided between the semiconductor region and a substrate electrode (That is, an electrode for applying the potential of the semiconductor region or the well, and hereinafter thus defined.) thereby obtaining a structure in which holes or electrons are readily accumulated in the substrate, and thus causing minority carrier (electron) injection from a source. Third, a low impurity concentration region is provided as a channel in the substrate surface region in order to prevent a rise in Vth due to the use of semiconductor region having a high impurity concentration.

By adopting the above described means, the present invention realizes an extremely high current driving capability by virtue of the effect of the minority carrier injection from the source that is triggered by an impact ionization phenomenon that occurs in the vicinity of the drain at a power supply voltage that is generally used and without depending upon the device size.

### BRIEF DESCRIPTION OF THE DRAWINGS

Fig.1 is a cross-sectional view showing a structure of a first embodiment of a semiconductor device according to the present invention;

Fig.2 is a cross-sectional view showing a structure of a conventional MOS transistor;

Fig .3 is a diagram showing a current path in the semiconductor device shown in Fig.1;

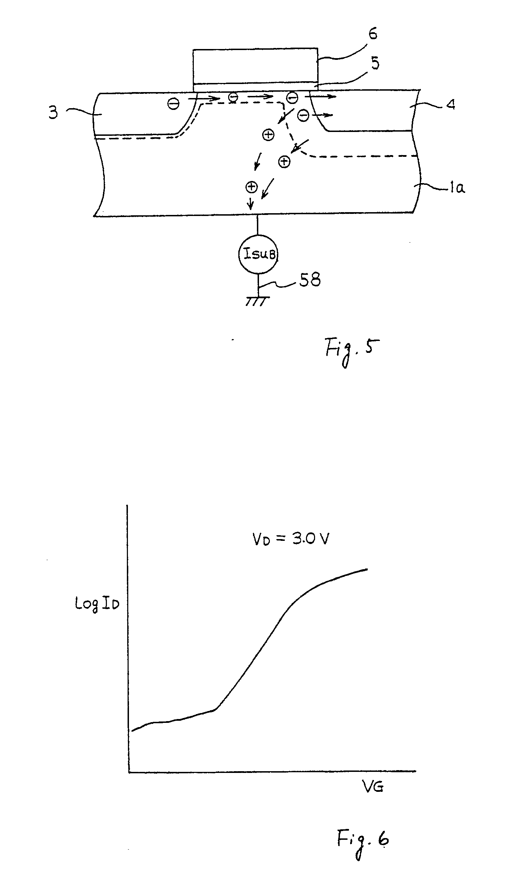

Fig.4 is a graph showing the current-voltage characteristics of the semiconductor device shown in Fig.1;

Fig.5 is a diagram showing a current path in the MOS transistor shown in Fig.2;

Fig.6 is a graph showing the current-voltage characteristics of the MOS transistor shown in Fig.2;

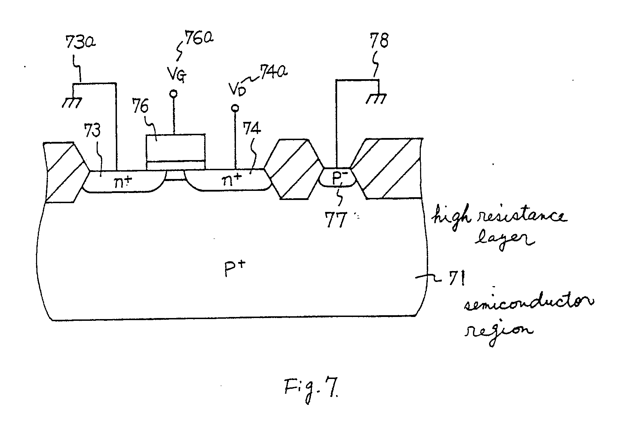

Fig.7 is a cross-sectional view of a structure of a semiconductor device of a second embodiment according to the present invention.

### THE BEST MODE FOR CARRYING OUT THE INVENTION

Hereinafter, the present invention is described in detail with reference to Fig.1, 3, 4, and 7.

Fig.1 is a cross-sectional view showing a structure of a first embodiment of a semiconductor device according to the present invention. A semiconductor substrate 1 having a high impurity concentration is a $P^+$ type substrate doped with, for example, boron, at a concentration of $1 \times 10^{18} \text{cm}^{-3}$

or more. A low-impurity region 2 is a P⁻ type region having a boron concentration of $1 \times 10^{16} \mathrm{cm}^{-3}$ or less, for example, and has a thickness of about 1,000Å or less. A source 3 and a drain 4 have been provided by use of ion implantation after the formation of a gate electrode 6 that is provided through a gate oxide film 5 which serves as a gate insulating film. A high-resistance layer 7 that is provided on the reverse side of the semiconductor substrate 1 is formed by predeposition of phosphorus on the reverse side of the semiconductor substrate 1. Not only an impurity diffusion layer but also an insulating film, such as a $SiO_2$ film, a SiN film, an $Si_3N_4$ film and a $Ta_2O_5$ film may be employed as the high-resistance layer 7 so as to serve as a resistance.

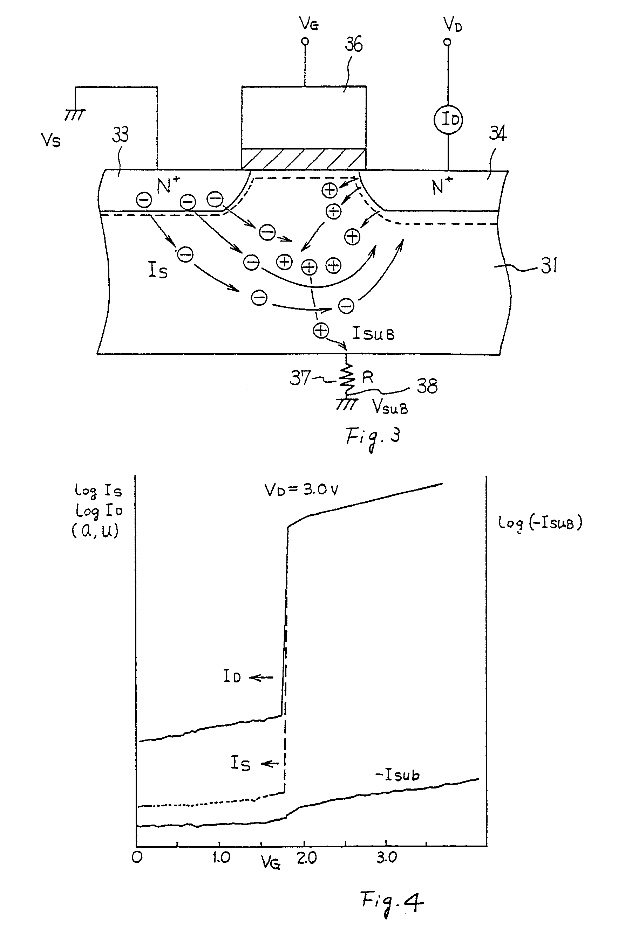

Fig.3 is a current path chart showing the operating principle of the semiconductor device according to the present invention. Electrodes include a source electrode 33, a drain electrode 34, a gate electrode 36, and a substrate electrode 31, among which the source electrode 33 is directly grounded and the substrate electrode 31 is grounded through a resistor R. The operating principle of the semiconductor device according to the present invention will be explained below by use of Fig.3. In case where the drain voltage is constant, i.e., $V_D$ = 5V, when the gate voltage $V_G$ is OV, no channel is formed, but a potential barrier of 5V alone is formed between the source and the substrate. Even when the channel is long (L ≥ 2μm), if the gate voltage $V_G \geq V_{th}$ (threshold voltage), a channel is formed, so that electrons are supplied from the source to the drain. At this time, some of the electrons become hot electrons at the side end portion of the drain, causing impact ionization, thus generating electron-hole pairs in the form of avalanche. At this time, holes (in case of an N channel transistor) are injected into the substrate and flow to the substrate electrode 58 in the form of a substrate current $I_{SUB}$, as shown in Fig.5. In the present invention, however, since the register R is provided just before the substrate electrode, holes (in case of a P channel transistor, electrons) are readily accumulated inside the substrate, so that the substrate potential is raised. Accordingly, the source and the substrate perform a forward operation, so that minority carriers (electrons) are injected into the substrate from the source. Some of the electrons injected from the source reach the drain while causing recombination to contribute as the drain current. As the sum total of the above described phenomena, a rapid increase in drain current occurs, as shown in Fig.4. Fig .4 shows an example in which the above described phenomenon occurs when the drain voltage $V_D$ is around 3.0V and the gate voltage $V_G$ is around 1.75V in the case of W/L = 20/10.

Thus, in the present invention an extremely high mutual conductance, which has heretofore been unavailable, is obtained at a drain voltage and a gate voltage, which are not higher than 5V. Incidentally, Figs.2, 5, and 6 are a cross-sectional view showing the structure of a conventional MOSFET, a current path chart thereof, and a graph showing the current-voltage characteristics thereof, respectively. In a structure such as shown in Fig.2, since the width of the depletion layer between the semiconductor substrate 1a and the drain 4 is large, as shown in Fig.5, substantially no impact ionization occurs at the drain end when the power supply voltage is at an ordinary level, so that a rapid increase in drain current such as seen in Fig.4 is not recognized in Fig. 6.

Fig.7 is a cross-sectional view of a structure of a second embodiment according to the present invention. In this embodiment, a high-resistance layer 77 is not provided on the reverse side of a substrate 71 as in the first embodiment, but on the surface side of the substrate as a diffusion layer. Even in this case, the impurity concentration in the high resistance layer is lower than that in the semiconductor region 71. Adopting this structure may also realize exactly the same effect as in the structure of the semiconductor device shown in Fig. 1.

As clearly understood according to the above description, it is not necessary to provide the high resistance layer on the reverse side or on the surface side of the semiconductor substrate when carrying out the present invention. Substantially important thing is, however, to provide a resistance of any form (including an external resistance if the situation allows) between the substrate and the ground electrode, thereby obtaining the structure wherein majority carriers are readily accumulated in the substrate.

These high resistance regions 37 and 77 are meant to have a function to make the holes or the electrons caused in the vicinity of the drains hardly run away from the substrates 1, 31 and 71 to the substrate electrodes 8, 38, and 78 (that is, electrodes for applying potentials to the semiconductor regions.) Therefore, the resistance of these high resistance regions need to be larger than that of the semiconductor regions 1, 31, and 71.

As has been described above, it is possible according to the present invention to produce a semiconductor device that is characterized by a high speed operation, which has heretofore been unavailable, by utilizing the effect of the minority carrier injection into the substrate.

## Claims

1. A semiconductor device comprising a semiconductor substrate of a first conductivity type, source and drain regions of a second conductivity type which is different from that of said first conductivity type, a gate insulating film that is provided over a channel region which extends between said source and drain regions, and a gate electrode that is provided on said gate insulating film, wherein said semiconductor substrate of said first conductivity type has a high impurity concentration, while said channel region that is directly below said gate insulating film has a lower impurity concentration than that of said semiconductor substrate, and a high resistance load is provided in series between said semiconductor substrate and a substrate electrode.

2. A semiconductor device according to claim 1; wherein said high resistance load is provided on the reverse side of said first conductivity type semiconductor substrate.

3. A semiconductor device according to claim 2; wherein said high resistance load is provided on the surface side of said first conductivity type semiconductor substrate.

4. A semiconductor device according to claim 1 or 2 or 3; wherein said high resistance load is an impurity diffusion layer having a low impurity concentration.

5. A semiconductor device according to claim 1 or 2 or 3; wherein said high resistance load is an insulating film such as $SiO_2$ film, SiN film, $Si_3N_4$ film and $Ta_2$ film.

6. A semiconductor substrate according to claim 1; wherein the thickness of said low impurity concentration region directly below the gate insulating film is 1,000Å or less.

7. A semiconductor device according to claim 6; wherein said impurity concentration region is an epitaxial growth layer.

8. A semiconductor device according to claim 1 having a structure wherein an impact ionization phenomenon occurs in the vicinity of the drain when the channel is $2\mu$m or more and the drain voltage $V_D$ is 5V or lower.

source electrode    gate electrode

3a    6a        drain electrode

$V_G$      $V_D$~4a

6   5      9 field oxide film

3         4

$n^+$     $n^+$

semiconductor substrate

2

low impurity concentration region   1

$P^+$

$P^-$    7

high resistance layer

8

substrate electrode

Fig. 1

23        26

25

$N^+$        $N^+$   24

P

21

Fig. 2

Fig. 3

Fig. 4

Fig. 5

$V_D = 3.0\ V$

Log $I_D$

$V_G$

Fig. 6

Fig. 7.

# INTERNATIONAL SEARCH REPORT

**I. CLASSIFICATION OF SUBJECT MATTER** (if several classification symbols apply, indicate all) 6

According to International Patent Classification (IPC) or to both National Classification and IPC

Int. Cl$^5$ H01L29/784

**II. FIELDS SEARCHED**

Minimum Documentation Searched 7

| Classification System | Classification Symbols |
|---|---|
| IPC : | H01L29/784 |

Documentation Searched other than Minimum Documentation
to the Extent that such Documents are Included in the Fields Searched 8

| | |
|---|---|
| Jitsuyo Shinan Koho | 1965 – 1990 |
| Kokai Jitsuyo Shinan Koho | 1971 – 1990 |

**III. DOCUMENTS CONSIDERED TO BE RELEVANT** 9

| Category* | Citation of Document, 11 with indication, where appropriate, of the relevant passages 12 | Relevant to Claim No. 13 |
|---|---|---|
| A | JP, A, 1-140772 (Hitachi, Ltd.), 1 June 1989 (01. 06. 89), (Family: none) | 1 – 8 |
| A | JP, B2, 55-13591 (Hitachi, Ltd.), 10 April 1980 (10. 04. 80) & US, A, 4132997 | 1 – 8 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| September 26, 1990 (26. 09. 90) | October 15, 1990 (15. 10. 90) |
| International Searching Authority | Signature of Authorized Officer |
| Japanese Patent Office | |

Form PCT/ISA/210 (second sheet) (January 1985)